(19) Europäisches Patentamt / European Patent Office / Office européen des brevets

(11) **EP 4 120 139 B1**

(12) **EUROPEAN PATENT SPECIFICATION**

(45) Date of publication and mention of the grant of the patent:
**25.02.2026 Bulletin 2026/09**

(21) Application number: **22174049.1**

(22) Date of filing: **18.05.2022**

(51) International Patent Classification (IPC):
**G06N 3/082** (2023.01)    **G06N 3/0455** (2023.01)
**G06N 3/0495** (2023.01)    **G06N 3/0985** (2023.01)
**G06N 3/063** (2023.01)    **G06N 3/048** (2023.01)

(52) Cooperative Patent Classification (CPC):
**G06N 3/082; G06N 3/0455; G06N 3/0495; G06N 3/0985;** G06N 3/048; G06N 3/063

(54) **A METHOD FOR SPARSIFICATION OF FEATURE MAPS IN SELF-ATTENTION MECHANISMS**

VERFAHREN ZUR SPARSIFIZIERUNG VON MERKMALSKARTEN IN SELBSTAUFMERKSAMKEITSMECHANISMEN

PROCÉDÉ DE PROJECTION DE CARTES DE CARACTÉRISTIQUES DANS DES MÉCANISMES D'AUTO-SURVEILLANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.07.2021 US 202163222405 P**
**14.09.2021 US 202117475330**

(43) Date of publication of application:
**18.01.2023 Bulletin 2023/03**

(73) Proprietor: **Samsung Electronics Co., Ltd.**
**Suwon-si, Gyeonggi-do 16677 (KR)**

(72) Inventors:
• **THORSLEY, David Philip Lloyd**
**Morgan Hill, CA, 95037 (US)**
• **SHEN, Chengyao**
**San Jose, CA, 95134 (US)**
• **HASSOUN, Joseph H.**
**Los Gatos, CA, 95032 (US)**
• **FANG, Jun**
**Santa Clara, CA, 95054 (US)**

(74) Representative: **Kuhnen & Wacker**
**Patent- und Rechtsanwaltsbüro PartG mbB**
**Prinz-Ludwig-Straße 40A**
**85354 Freising (DE)**

(56) References cited:
• **SAURABH GOYAL ET AL: "PoWER-BERT: Accelerating BERT Inference via Progressive Word-vector Elimination", ARXIV.ORG, CORNELL UNIVERSITY LIBRARY, 201 OLIN LIBRARY CORNELL UNIVERSITY ITHACA, NY 14853, 8 September 2020 (2020-09-08), XP081756882**
• **DEVLIN JACOB ET AL: "BERT: Pre-training of Deep Bidirectional Transformers for Language Understanding", 24 May 2019 (2019-05-24), XP055834934, Retrieved from the Internet <URL:https://arxiv.org/pdf/1810.04805.pdf> [retrieved on 20210825]**
• **WANG HANRUI ET AL: "SpAtten: Efficient Sparse Attention Architecture with Cascade Token and Head Pruning", 2021 IEEE INTERNATIONAL SYMPOSIUM ON HIGH-PERFORMANCE COMPUTER ARCHITECTURE (HPCA), IEEE, 27 February 2021 (2021-02-27), pages 97 - 110, XP033905611, DOI: 10.1109/ HPCA51647.2021.00018**
• **ZHANG AIDONG ET AL: "Learned Token Pruning for Transformers", 23 September 2021 (2021-09-23), New York, NY, USA, pages 1 - 14, XP055968632, ISBN: 978-1-4503-9385-0, Retrieved from the Internet <URL:https://arxiv. org/pdf/2107.00910v2.pdf> [retrieved on 20221111], DOI: 10.1145/3534678.3539260**

- **WIEDEMANN SIMON ET AL: "DeepCABAC: A Universal Compression Algorithm for Deep Neural Networks", ARXIV (CORNELL UNIVERSITY), 27 July 2019 (2019-07-27), pages 1 - 18, XP093191127, Retrieved from the Internet <URL:https://arxiv.org/pdf/1907.11900> [retrieved on 20240820], DOI: 10.48550/ arxiv.1907.11900**
- **TEUHBLA JUKLCA: "A COMPRESSION METHOD FOR CLUSTERED BIT-VECTORS", 1 October 1978 (1978-10-01), pages 1 - 4, XP093251241, Retrieved from the Internet <URL:https://pdf. sciencedirectassets.com/271527/ 1-s2.0-S0020019000X02426/ 1-s2.0-0020019078900248/main.pdf? hash=12096d8b16e5846938eeb76 f8a1437195403396bc609b4b56af2107d236682 b0&host=68042c943591013ac2b2430a89b270f6a f2c76d8dfd086a07176afe7c76c2c61&pi i=0020019078900248& tid=spdf-daec80e2-3ded-425f-b8a5-bf91d>  [retrieved on 20250218]**

## Description

TECHNICAL FIELD

The subject matter disclosed herein relates to neural networks. More particularly, the subject matter disclosed herein relates to a technique for reducing computation associated with a transformer deep-learning neural network.

BACKGROUND

Transformer deep-learning models are considered to be state-of-the-art processing techniques for many natural-language processing tasks. Multi-head self-attention is a core feature of many of the transformer deep-learning models.

SAURABH GOYAL ET AL: "POWER-BERT: Accelerating BERT Inference via Progressive Word-vector Elimination", ARXIV.ORG, CORNELL UNIVERSITY LIBRARY, 201 OLIN LIBRARY CORNELL UNIVERSITY ITHACA, NY 14853, 8 September 2020 (2020-09-08), discusses Accelerating BERT Inference via Progressive Word-vector Elimination.

SUMMARY

The invention is set out in the appended claims.

BRIEF DESCRIPTION OF THE DRAWING

In the following section, the aspects of the subject matter disclosed herein will be described with reference to exemplary embodiments illustrated in the figures, in which:

FIG. 1A depicts a functional block diagram of an example transformer deep-learning model;
FIG. 1B depicts a block diagram of an example multi-head attention layer of the example transformer deep-learning model;
FIG. 1C depicts details of a scaled dot-product attention layer of the example transformer deep-learning model; and
FIG. 2 depicts an example sequence for reducing computation involved during deep neural network training according to the subject matter disclosed herein.

DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system-on-a-chip (SoC), an assembly, and so forth.

A self-attention mechanism is quadratic with respect to the length of an input sequence (i.e., the length of the input sentence). Accordingly, longer sequences involve significantly more computation. Feature-map sparsity in transformers may improve efficiency. The subject matter disclosed herein provides a method for reducing the computation involved during deep neural network training by: training with L1 regularization to induce sparsity in the key, query, value, attention score, and context signals in a self-attention mechanism; adding an activation layer at training and inference time to zero out small activations, and quantizing and encoding an output result.

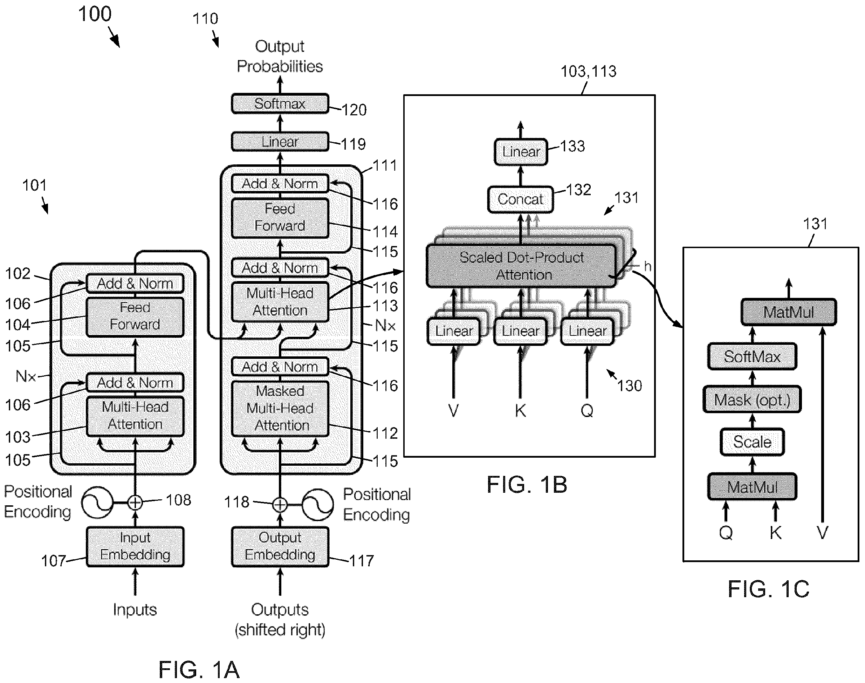

FIG. 1A depicts a functional block diagram of an example transformer deep-learning model 100. The transformer model 100 may include an encoder 101 and a decoder 110. The encoder 101 and/or the decoder 110 may be embodied as one or more modules. The encoder 101 may include N layers 102 in which N is an integer. Each layer 102 may include a multi-head attention sublayer 103 and a feed-forward sublayer 104. A residual connection 105 may be used around each sublayer 103 and 104, followed by a layer normalization 106. Inputs to the encoder 101 (e.g., target sentences) may be embedded at 107 into an n-dimensional space. Positional encoding 108 may be added to the embedded representation of the inputs.

Similar to the encoder 101, the decoder 110 may include N layers 111. Each layer 111 may include a masked multi-head attention sublayer 112, a multi-head attention layer 113, and a feed-forward sublayer 114. A residual connection 115 may be used around each sublayer 113 and 114, followed by a layer normalization 116. The masked multi-head attention sublayer 112 prevents positions from attending to subsequent positions. Outputs of the decoder 110 may be embedded at 117 and positionally offset at 118 by one position so that predictions for a position i may depend only on the known outputs at positions less that i.

Outputs of the decoder 111 may be input to a linear classifier layer 119 and then to a Softmax layer 120, which outputs probabilities that may be used to predict a next token in an output sequence.

The multi-head self-attention model 100 may include several matrix multiplication operations that use no static weights. FIG. 1B depicts a block diagram of an example multi-head attention layer 102, 113. As depicted in FIG. 1B, a multi-head attention layer may include $h$ linear projections 130 of matrices V, K and Q, $h$ scaled dot-product attention layers 131 in which $h$ is an integer, a concatenation layer 132 and a linear classifier layer 133.

A multi-head attention layer 102, 113 may be parallelized with linear projections of V, K and Q. V may be a matrix (i.e., a feature map) of the values that are again the vector representations of all the words in the sequence, *K* may be a matrix (i.e., a feature map) all the keys (vector representations of all the words in the sequence), and *Q* may be a matrix (i.e., a feature map) that contains a query (vector representation of one word in the sequence). The parallelization allows the transformer model 100 to beneficially learn from different representations of *V, K* and *Q*. The linear representations are formed by multiplying *V, K* and *Q* by weight matrices *W* that are learned during the training. The matrices *V, K* and *Q* may be different for each position of the attention modules in the structure depending on whether they are in the encoder 101, the decoder 110, or in-between the encoder 101 and decoder 110 so that either the whole or a part of encoder input sequence may be attended. A multi-head attention module that connects the encoder 101 and the decoder 110 takes a encoder input sequence into account together with a decoder input-sequence up to a given position.

After the multi-attention heads in both the encoder and decoder, a pointwise feed-forward layer 104, 114 may be included after multi-attention heads 103, 113 in both the encoder 101 and the decoder 110. Each feed-forward network 104, 114 may include identical parameters for each position that may provide a separate, identical linear transformation for each element from the given sequence.

FIG. 1C depicts details of a scaled dot-product attention layer 131. The inputs to a scaled dot-product attention layer 131 may include queries, keys of dimension $d_k$, and values of dimension $d_v$. Dot products of the query with all keys are computed and each dot product is divided by $\sqrt{d_k}$. A softmax function may then be applied to obtain the scores, or probabilities, for the values. The attention function is computed on a set of queries simultaneously, and combined into a matrix *Q*. The keys and values are also respectively combined together into matrices *K* and *V*. A matrix of outputs is computed as:

$$Attention\,(Q,K,V) = softmax\left(\frac{QK^T}{\sqrt{d_k}}\right)V, \qquad (1)$$

in which $K^T$ is the transpose of matrix *K*.

Eq. (1) may be rewritten as the values in *V* multiplied and summed with attention-weights *a* in which the weights are defined by:

$$a = softmax\left(\frac{QK^T}{\sqrt{d_k}}\right). \qquad (2)$$

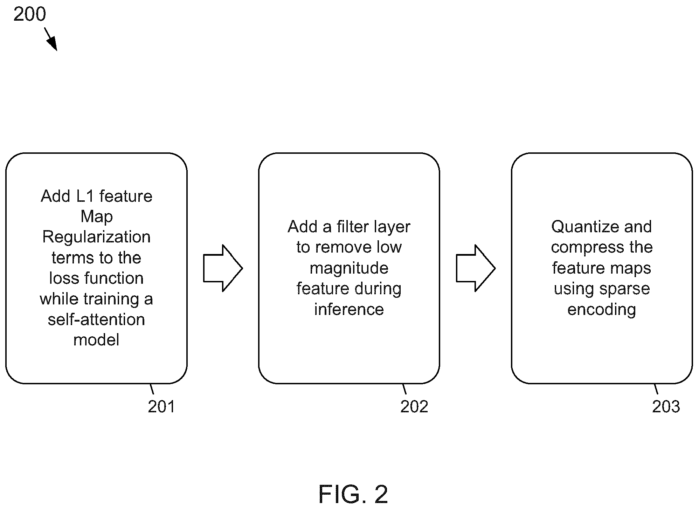

FIG. 2 depicts an example sequence 200 for reducing computation involved during deep neural network training according to the subject matter disclosed herein. At 201, an L1 regularization may be applied to a loss function during training to increase sparsity. At 202, a filter layer may be added to remove, or prune, low-magnitude features during a forward pass of training and during inference. Filter layers may be added to remove, or prune, query feature maps, key feature maps, value feature maps, attention scores, attention probabilities, and context. In one embodiment, the filter layer at 202 is a function *f(x)* that sets *x* to zero if the absolute value of *x* is less than a predetermined threshold and does not change the value of *x* if *x* is greater than or equal to the predetermined threshold. It should be noted that as the percentage of activations pruned increases, the accuracy of the model may be adversely affected, as shown in Table 3. Nevertheless, some pruning may beneficially reduce computation while not significantly adversely affecting model accuracy. At 203 after training, the model weights and feature maps may be quantized and compressed.

A network may be trained in a standard fashion using a cost function such as in Eq. (3):

$$E_0(w) = \frac{1}{N}\sum_{n=1}^{N} c_n(w) + \lambda_w r(w) \qquad (3)$$

in which *N* is a mini-batch size, $c_n(\cdot)$ is a cost function (e.g., cross-entropy), $\lambda$ is a regularization parameter, and $r(\cdot)$ is a weight regularization function (e.g., L2). A standard dense neural network training may use L2 regularization to keep the magnitudes of the weights relatively small, which is described in Eq. (3).

When fine-tuning a network, the loss function of Eq. (3) may be modified to promote activation sparsity as

$$E_0(w) = \frac{1}{N}\sum_{n=1}^{N} c'_n(w) + \lambda_w r(w), \qquad (4)$$

$$c'_n(w) = c_n(w) + \frac{1}{N}\sum_{l=0}^{L} \alpha_l \left\| x_{l,n} \right\|_1 \qquad (5)$$

in which $L$ is the number of layers in model, $\alpha_l(\cdot)$ is a layer weightings, and $x_{l,n}$ is a feature map for layer $l$, sample $n$. The regularization function $r(w)$ in Eq. (4) uses an L1 regularization. In Eq. (3) either an L1 and an L2 regularization may be used, but in Eqs. (4) and (5), an L1 regularization should be used.

After training in full precision, weights may be quantized in a usual post-training fashion. For example, at least an 8-bit uniform quantization may be used, such as

$$x_l^{quant} = \frac{x_l - x_l^{min}}{x_l^{max} - x_l^{min}}(2^b - 1). \qquad (6)$$

For a non-negative integer $x$, $x + 1$ may be converted to binary, and $\lceil \log_2(x+1) \rceil$ may be prepended with zeros. If the binary representation is $n$ bits, $n - 1$ bits are prepended. An order $k$ exp-Golomb code may be: Encode $\lfloor x/2^k \rfloor$ using $\lceil \log_2(x+1) \rceil$; append $x$ mod $2^k$ in binary, and append $k$ bits. Table 1 shows example Exponential-Golomb (EG(x,k)) coding values for $x = 0, ..., 4$, and $k = 0$ and 2. Larger orders of $k$ may allow larger values of $x$ to be coded with fewer bits. It will, however, take $k + 1$ bits to encode $x = 0$.

Table 1.

| x | EG(x,0) | EG(x,2) |
|---|---------|---------|
| 0 | 0 | 100 |
| 1 | 010 | 101 |
| 2 | 011 | 110 |
| 3 | 00100 | 111 |
| 4 | 00101 | 01000 |

The order $k$ sparse-exp-Golomb code, $k > 0$, is:

1 if $x = 0$,
0 + EG(x-1, k) otherwise.

A shortest possible code is when $x = 0$, so sparse maps may be compressed efficiently. The value of $k$ may be chosen to minimize the mean code length. For uint16-quantized values, the value of k is typically between 10 and 13. Table 2 shows example Exponential-Golomb coding values and Sparse Exponential-Golomb (SEG) coding values for $x = 0, ...,$ 4, and $k = 0$ and 2, i.e., EG(x,0), EG(x,2) and SEG(x,2).

Table 2.

| x | EG(x,0) | EG(x,2) | SEG(x,2) |
|---|---------|---------|----------|
| 0 | 1 | 100 | 1 |
| 1 | 010 | 101 | 0100 |
| 2 | 011 | 110 | 0101 |
| 3 | 00100 | 111 | 0110 |
| 4 | 00101 | 01000 | 0111 |

This coding scheme may be extended to signed integers as

$$SSEG(x,\,k) = \begin{cases} SEG(2x-1,\,k) & x > 0 \\ SEG(-2x,\,k) & x \leq 0 \end{cases} \qquad (7)$$

By adjusting the values of the layer weights, a trade off may be made between the sparsity of the activation feature maps and the accuracy of the model.

Self-attention modules may have more feature maps than weights. Consequently, increasing weight sparsity may not accelerate self-attention computation. Increasing activation sparsity may accelerate computation of both self-attention modules and feed-forward modules.

Feature maps have exponential distributions, and signed exp-Golomb coding may be used in a straightforward fashion to sparsify feature maps. Other coding techniques may alternatively be used.

Regularization may be expanded as follows because self-attention blocks may have a more varied set of activation maps. For example,

$$E_0(w) = \frac{1}{N} \sum_{n=1}^{N} c_n'(w) + \lambda_w r(w) \qquad (8)$$

$$c_n'(w) = c_n(w) + \frac{1}{N} \sum_{l=0}^{L} \alpha_{q,l} \|q_{l,n}\|_1 + \frac{1}{N} \sum_{l=0}^{L} \alpha_{k,l} \|k_{l,n}\|_1$$

$$+ \frac{1}{N} \sum_{l=0}^{L} \alpha_{v,l} \|v_{l,n}\|_1 + \frac{1}{N} \sum_{l=0}^{L} \alpha_{s,l} \|s_{l,n}\|_1 \qquad (9)$$

$$+ \frac{1}{N} \sum_{l=0}^{L} \alpha_{p,l} \|p_{l,n}\|_1 + \frac{1}{N} \sum_{l=0}^{L} \alpha_{c,l} \|c_{l,n}\|_1 + \cdots$$

in which $L$ is the number of self-attention modules in model, $\alpha._l(\cdot)$ is a feature map weighting, and $\cdot_{l,n}$ is feature map $l$, sample $n$. These signals may be sparsified using the L1 norm. After a model is trained with regularization, as described above, the model will have many small-value activations, but not necessarily many activations that have a zero value. A filter function may be added after each signal to zero out the activations that are almost, but not quite zero. This is possible with a minimal loss in accuracy. The model may also be fine tuned with filter functions in further place to improve accuracy.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations, one or more features from a claimed combination may in some cases be excised from the combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. Additionally, the processes depicted in the accompanying figures do not necessarily require the particular order shown, or sequential order, to achieve desirable results. In certain implementations, multitasking and parallel processing may be advantageous.

# EP 4 120 139 B1

## Claims

1. A computer-implemented method (200) to reduce computation in a self-attention model (100), the computer-implemented method (200) comprising:

   adding (201) a feature-map regularization term to a loss function while training the self-attention model (100);
   removing (202) at least one low-magnitude feature from at least one feature map of the self-attention model (100) during inference;
   quantizing weights of the self-attention model (100) after the self-attention model (100) has been trained; and
   compressing quantized weights based on an Exponential-Golomb coding technique,
   wherein removing (202) the at least one low-magnitude feature from at least one feature map comprises setting the at least one low-magnitude feature to be equal to zero based on the low-magnitude features having a value that is less than a predetermined threshold,

   wherein:

   the loss function is a loss function of the self-attention model (100),
   the self-attention model (100) comprises an encoder (101) and a decoder (110),
   the step of removing (202) at least one low-magnitude feature from at least one feature map comprises removing at least one low-magnitude feature from at least one feature map of the decoder (110) during inference, and
   the step of quantizing weights of the self-attention model (100) comprises quantizing weights of the decoder (110).

2. The computer-implemented method (200) of claim 1, further comprising quantizing feature maps of the self-attention model (100); and
   compressing quantized feature maps.

3. The computer-implemented method (200) of claim 1 or 2, wherein quantizing weights comprises using at least 8-bit quantization.

4. The computer-implemented method (200) of any one of claims 1 to 3, further comprising compressing at least one feature map of the self-attention model (100).

5. A data-processing apparatus implementing a transformer deep-learning model, comprising:

   an encoder (101) having multiple layers, each encoder layer including a multi-head attention sublayer that processes an encoder (101) query feature map $Q$, an encoder (101) key feature map $K$, and an encoder (101) value feature map $V$, and each encoder layer being trained by adding a feature-map regularization term to a loss function for the encoder (101), having at least one low-magnitude feature removed from at least one of the encoder $Q$, $K$ and $V$ feature maps, and having weights of the encoder (101) quantized; and
   a decoder (110) having multiple layers, each decoder layer including a multi-head attention sublayer that processes a decoder (110) query feature map $Q$, a decoder (110) key feature map $K$, and a decoder (110) value feature map $V$, and each decoder layer being trained by adding a feature-map regularization term to a loss function for the decoder (110), having at least one low-magnitude feature removed from at least one of the decoder $Q$, $K$ and $V$ feature maps, and having weights of the decoder (110) quantized,
   wherein the quantized weights of the decoder (110) are compressed based on an Exponential-Golomb coding technique,
   wherein the at least one low-magnitude feature removed from the at least one of the encoder (101) and the decoder (110) is removed by setting the low-magnitude feature to be equal to zero based on the low-magnitude feature having a value that is less than a predetermined threshold.

6. The data-processing apparatus of claim 5, wherein at least one feature map of the computer-implemented transformer deep-learning model is compressed.

## Patentansprüche

1. Computerimplementiertes Verfahren (200) zur Reduzierung des Rechenaufwands in einem Selbstaufmerksamkeitsmodell (100), wobei das computerimplementierte Verfahren (200) aufweist:

Hinzufügen (201) eines Feature-Map-Regularisierungsterms zu einer Verlustfunktion während des Trainierens des Selbstaufmerksamkeitsmodells (100);

Entfernen (202) von zumindest einem Feature von geringer Größenordnung aus zumindest einem Feature-Map des Selbstaufmerksamkeitsmodells (100) während einer Inferenz;

Quantisieren der Gewichte des Selbstaufmerksamkeitsmodells (100), nachdem das Selbstaufmerksamkeitsmodell (100) trainiert worden ist; und

Komprimieren quantisierter Gewichte basierend auf einer Exponential-Golomb-Kodierungstechnik,

wobei das Entfernen (202) des zumindest einen Feature von geringer Größenordnung aus zumindest einer Feature-Map ein Setzen des zumindest einen Feature von geringer Größenordnung auf Null basierend auf den Features von geringer Größenordnung umfasst, welche einen Wert haben, der kleiner als ein vorbestimmter Schwellenwert ist,

wobei:

die Verlustfunktion eine Verlustfunktion des Selbstaufmerksamkeitsmodells (100) ist,

das Selbstaufmerksamkeitsmodell (100) einen Encoder (101) und einen Decoder (110) umfasst,

der Schritt des Entfernens (202) von zumindest einem Feature von geringer Größenordnung aus zumindest einer Feature-Map ein Entfernen von zumindest einem Feature von geringer Größenordnung aus zumindest einer Feature-Map des Decoders (110) während der Inferenz umfasst, und

der Schritt des Quantisierens von Gewichten des Selbstaufmerksamkeitsmodells (100) ein Quantisieren von Gewichten des Decoders (110) umfasst.

2. Computerimplementiertes Verfahren (200) nach Anspruch 1, das ferner ein Quantisieren von Feature-Maps des Selbstaufmerksamkeitsmodells (100); und ein Komprimieren von quantisierten Feature-Maps umfasst.

3. Computerimplementiertes Verfahren (200) nach Anspruch 1 oder 2, wobei das Quantisieren von Gewichten ein Verwenden von zumindest einer 8-Bit-Quantisierung umfasst.

4. Computerimplementiertes Verfahren (200) nach einem der Ansprüche 1 bis 3, das ferner ein Komprimieren von zumindest einer Feature-Map des Selbstaufmerksamkeitsmodells (100) umfasst.

5. Datenverarbeitungsvorrichtung, die ein Transformer-Deep-Learning-Modell implementiert, aufweisend:

einen Encoder (101) mit mehreren Schichten, wobei jede Encoder-Schicht eine Multi-Head-Attention-Unterschicht umfasst, die eine Abfrage-Feature-Map Q eines Encoders (101), eine Key-Feature-Map K eines Encoders (101) und eine Wert-Feature-Map V eines Encoders (101) verarbeitet, und wobei jede Encoder-Schicht durch Hinzufügen eines Feature-Map-Regularisierungsterms zu einer Verlustfunktion für den Encoder (101) trainiert wird, wobei zumindest ein Feature von geringer Größenordnung aus zumindest einer der Feature-Maps Q, V, K des Encoders entfernt wird und die Gewichte des Encoders (101) quantisiert werden; und

einen Decoder (110) mit mehreren Schichten, wobei jede Decoder-Schicht eine Multi-Head-Attention-Unterschicht umfasst, die eine Abfrage-Feature-Map Q eines Decoders (110), eine Key-Feature-Map K eines Decoders (110) und eine Wert-Feature-Map V eines Decoders (110) verarbeitet, und wobei jede Decoder-Schicht durch Hinzufügen eines Feature-Map-Regularisierungsterms zu einer Verlustfunktion für den Decoder (101) trainiert wird, wobei zumindest ein Feature von geringer Größenordnung aus zumindest einer der Feature-Maps Q, V, K des Decoders entfernt wird und die Gewichte des Decoders (110) quantisiert werden,

wobei die quantisierten Gewichte des Decoders (110) auf der Grundlage einer Exponential-Golomb-Kodierungstechnik komprimiert werden,

wobei das zumindest eine Feature von geringer Größenordnung, das aus dem zumindest einen Encoder (101) und/oder Decoder (110) entfernt wurde, entfernt wird durch Setzen des Feature von geringer Größenordnung auf Null basierend auf dem Feature von geringer Größenordnung, das einen Wert hat, der kleiner als ein vorbestimmter Schwellenwert ist.

6. Datenverarbeitungsvorrichtung nach Anspruch 5, wobei zumindest ein Feature-Map des computerimplementierten Transformer-Deep-Learning-Modells komprimiert wird.

**Revendications**

1.  Procédé mis en œuvre par ordinateur (200) pour réduire le calcul dans un modèle d'auto-attention (100), le procédé mis en œuvre par ordinateur (200) comprenant :

    l'ajout (201) d'un terme de régularisation de carte de caractéristiques à une fonction de perte pendant l'entraînement du modèle d'auto-attention (100) ;
    la suppression (202) d'au moins une caractéristique de faible amplitude à partir d'au moins une carte de caractéristiques du modèle d'auto-attention (100) pendant l'inférence ;
    la quantification des poids du modèle d'auto-attention (100) après que le modèle d'auto-attention (100) a été entraîné ; et
    la compression des poids quantifiés sur la base d'une technique de codage d'Exponential-Golomb,
    dans lequel la suppression (202) de l'au moins une caractéristique de faible amplitude à partir de l'au moins une carte de caractéristiques comprend la mise de ladite au moins une caractéristique de faible amplitude à une valeur égale à zéro sur la base du fait que les caractéristiques de faible amplitude ont une valeur inférieure à un seuil prédéterminé,
    dans lequel :

    la fonction de perte est la fonction de perte du modèle d'auto-attention (100),
    le modèle d'auto-attention (100) comprend un encodeur (101) et un décodeur (110),
    l'étape de suppression (202) de l'au moins une caractéristique de faible amplitude à partir de l'au moins une carte de caractéristiques comprend la suppression d'au moins une caractéristique de faible amplitude à partir d'au moins une carte de caractéristiques du décodeur (110) pendant l'inférence, et
    l'étape de quantification des poids du modèle d'auto-attention (100) comprend la quantification des poids du décodeur (110).

2.  Procédé mis en œuvre par ordinateur (200) selon la revendication 1, comprenant en outre la quantification des cartes de caractéristiques du modèle d'auto-attention (100) ; et
    la compression des cartes de caractéristiques quantifiées.

3.  Procédé mis en œuvre par ordinateur (200) selon la revendication 1 ou 2, dans lequel la quantification des poids comprend l'utilisation d'une quantification d'au moins 8 bits.

4.  Procédé mis en œuvre par ordinateur (200) selon l'une quelconque des revendications 1 à 3, comprenant en outre la compression d'au moins une carte de caractéristiques du modèle d'auto-attention (100).

5.  Appareil de traitement de données mettant en œuvre un modèle d'apprentissage profond de type transformeur, comprenant :

    un encodeur (101) ayant plusieurs couches, chaque couche d'encodeur comprenant une sous-couche d'attention multi-têtes qui traite une carte de caractéristiques de requête Q de l'encodeur (101), une carte de caractéristiques de clé K de l'encodeur (101) et une carte de caractéristiques de valeur V de l'encodeur (101), et chaque couche d'encodeur étant entraînée par l'ajout d'un terme de régularisation de carte de caractéristiques à une fonction de perte pour l'encodeur (101), ayant au moins une caractéristique de faible amplitude supprimée à partir d'au moins l'une des cartes de caractéristiques Q, K et V de l'encodeur, et ayant les poids de l'encodeur (101) quantifiés ; et
    un décodeur (110) ayant plusieurs couches, chaque couche de décodeur comprenant une sous-couche d'attention multi-têtes qui traite une carte de caractéristiques de requête Q du décodeur (110), une carte de caractéristiques de clé K du décodeur (110) et une carte de caractéristiques de valeur V du décodeur (110), et chaque couche de décodeur étant entraînée par l'ajout d'un terme de régularisation de carte de caractéristiques à une fonction de perte pour le décodeur (110), ayant au moins une caractéristique de faible amplitude supprimée à partir d'au moins l'une des cartes de caractéristiques Q, K et V du décodeur, et ayant les poids du décodeur (110) quantifiés,
    dans lequel les poids quantifiés du décodeur (110) sont compressés sur la base d'une technique de codage d'Exponential-Golomb,
    dans lequel l'au moins une caractéristique de faible amplitude supprimée à partir de l'au moins un de l'encodeur (101) et du décodeur (110) est supprimée par la mise de la caractéristique de faible amplitude à une valeur égale à zéro sur la base du fait que ladite caractéristique de faible amplitude a une valeur inférieure à un seuil prédéterminé.

6.  Appareil de traitement de données selon la revendication 5, dans lequel au moins une carte de caractéristiques du modèle d'apprentissage profond de type transformeur mis en œuvre par ordinateur est compressée.

FIG. 1A

FIG. 1B

FIG. 1C

200

| Add L1 feature Map Regularization terms to the loss function while training a self-attention model | Add a filter layer to remove low magnitude feature during inference | Quantize and compress the feature maps using sparse encoding |

201          202          203

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- POWER-BERT: Accelerating BERT Inference via Progressive Word-vector Elimination. **SAURABH GOYAL et al.** ARXIV.ORG. CORNELL UNIVERSITY LIBRARY, 08 September 2020